# EUROPÄISCHE PATENTANMELDUNG

(11) **EP 3 584 933 A1**
(43) Veröffentlichungstag der Anmeldung: **25.12.2019**
(21) Anmeldenummer: 18178578.3
(22) Anmeldetag: 19.06.2018
(51) Int. Cl.: H03K 17/94, H03K 17/96, H05K 5/00, H02B 1/46

(54) **OPTOELEKTRONISCHE BEDIENEINHEIT ZUR BEDIENUNG EINER VORRICHTUNG, INSBESONDERE EINES WECHSELRICHTERS UND WECHSELRICHTERGEHÄUSE**

(71) Anmelder: FRONIUS INTERNATIONAL GmbH, 4643 Pettenbach (AT)
(72) Erfinder: GROSSAUER, Carina, 4484 Kronstorf (AT); GANGLMAIR, Sarim, 4651 Stadl-Paura (AT); MADERTHANER, Florian, 4020 Linz (AT); LEITGEB, Ronald, 9361 St. Salvator (AT)
(74) Vertreter: Sonn & Partner Patentanwälte

(57) **Zusammenfassung**

Die Erfindung betrifft eine optoelektronische Bedieneinheit (1) zur Bedienung einer Vorrichtung, insbesondere eines Wechselrichters (10), mit zumindest einem Reflexions-Lichttaster (2) mit jeweils einer Lichtquelle (3) und jeweils einem neben der Lichtquelle (3) angeordneten Lichtdetektor (4), einer Auswerteelektronik (5), und mit einer über der Lichtquelle (3) und dem Lichtdetektor (4) jedes Reflexions-Lichttasters (2) angeordneten Bedienfläche (6) zur Bedienung des Reflexions-Lichttasters (2) durch die Annäherung eines Objekts (7) sowie ein Wechselrichtergehäuse (15) mit einer solchen optoelektronischen Bedieneinheit (1). Erfindungsgemäß ist zwischen jeder Bedienfläche (6) und der Lichtquelle (3) und dem Lichtdetektor (4) eines Reflexions-Lichttasters (2) ein Lichtleiter (8) angeordnet, und eine Signallichtquelle (9) zur Aussendung von Licht im sichtbaren Wellenlängenbereich derart angeordnet, sodass das von der Signallichtquelle (9) ausgesendete Licht im sichtbaren Wellenlängenbereich über den Lichtleiter (8) auf die Bedienfläche (6) projizierbar ist.

## Beschreibung

Die Erfindung betrifft eine optoelektronische Bedieneinheit zur Bedienung einer Vorrichtung, insbesondere eines Wechselrichters, mit zumindest einem Reflexions-Lichttaster mit jeweils einer Lichtquelle und jeweils einem neben der Lichtquelle angeordneten Lichtdetektor, einer Auswerteelektronik, und mit einer über der Lichtquelle und dem Lichtdetektor jedes Reflexions-Lichttasters angeordneten Bedienfläche zur Bedienung des Reflexions-Lichttasters durch die Annäherung eines Objekts.

Weiters betrifft die Erfindung ein Wechselrichtergehäuse mit zumindest zwei über Befestigungselemente lösbar miteinander verbindbaren Gehäuseteilen, einem Anschlussbereich und einem an einem Gehäuseteil vorgesehenen Bedienbereich.

Üblicherweise erfolgt die Bedienung von Vorrichtungen, beispielsweise von Wechselrichtern, wie Photovoltaik-Wechselrichtern, mithilfe mechanischer Bedienelemente, wie z.B. Tastern oder Schaltern. Mechanische Bedienelemente unterliegen einem gewissen Verschleiß und benötigen darüber hinaus relativ viel Platz auf der jeweiligen Vorrichtung, der nicht immer zur Verfügung steht. Darüber hinaus ist die Montage und Demontage mechanischer Bedienelemente durch die notwendigen Verdrahtungen relativ zeitaufwändig und darüber hinaus fehleranfällig.

Verbesserungen liefern dabei optoelektronische Bedieneinheiten, die den zusätzlichen Vorteil aufweisen, dass keine spannungsführenden Teile an den Bedienbereich der jeweiligen Vorrichtung, beispielsweise des Wechselrichters, geführt werden müssen und dadurch eine galvanische Trennung des Bedienelements zur jeweiligen Vorrichtung, beispielsweise des Wechselrichters, geschaffen wird.

Das EP 2 577 869 B1 beschreibt beispielsweise ein optoelektronisches Bedienelement, bei dem eine als Anzeige vorgesehene Leuchtdiode zur Durchführung von Schaltvorgängen verwendet wird, indem diese Leuchtdiode beispielsweise durch einen Finger eines Benutzers abgedunkelt wird. Auch bei dieser Variante einer Bedieneinheit ist jedoch die Verkabelung der als Bedienelement herangezogenen Leuchtdiode erforderlich, was einen entsprechenden Montage- und Demontageaufwand mit sich bringt.

Bei vielen Vorrichtungen, insbesondere auch Wechselrichtern, wie z.B. Photovoltaik-Wechselrichtern, befindet sich der Bedienbereich an der von außen zugänglichen Seite des Gehäuses der Vorrichtung, beispielsweise des Wechselrichtergehäuses, wohingegen die Platine mit der jeweiligen Elektronik und auch der Auswerteelektronik für die optoelektronische Bedieneinheit im gegenüberliegenden Teil des Gehäuses der Vorrichtung eingebaut ist. Im Falle eines Photovoltaik-Wechselrichters sind die notwendigen Anschlüsse für die Photovoltaik-Module und die Verbindung mit dem Versorgungsnetz oder den Verbrauchern meist am Rand der Platine in einem eigenen, vom Leistungsbereich getrennten Anschlussbereich angeordnet, von wo entsprechende Zuleitungen durch Öffnungen im Gehäuse zu den Photovoltaik-Modulen und zum Versorgungsnetz oder den Verbrauchern führen. Bei der Montage, Demontage und Wartung einer Vorrichtung, insbesondere eines Photovoltaik-Wechselrichters, ist ein Öffnen des Wechselrichtergehäuses notwendig, was bei einer Verkabelung der notwendigen Bedienelemente zu einem erhöhten Aufwand führt, da die Verbindungsleitungen zu dem jeweiligen Bedienelement gelöst werden müssen, bevor der Anschlussbereich im Gehäuse der Vorrichtung bzw. im Wechselrichtergehäuse frei zugänglich ist. Darüber hinaus müssen allfällige Verbindungsleitungen zu Bedienungselementen gegenüber Anschlussleitungen, beispielsweise zu Photovoltaik-Modulen oder dem Versorgungsnetz, entsprechend isoliert werden.

Bei Verwendung optoelektronischer Bedienelemente, wie z.B. gemäß der US 2003/0020004 A1, können zwar mechanische Elemente, welche einem höheren Verschleiß unterliegen, vermieden werden, eine Verkabelung der Lichtquellen und Lichtdetektoren des Reflexions-Lichttasters zur jeweiligen Auswerteelektronik ist jedoch nach wie vor erforderlich und muss gegenüber spannungsführenden Teilen entsprechend isoliert und gesichert werden.

Die Aufgabe der vorliegenden Erfindung besteht in der Schaffung einer optoelektronischen Bedieneinheit und eines Wechselrichtergehäuses, durch welche eine optimale Bedienung der jeweiligen Vorrichtung, insbesondere des Wechselrichters, ermöglicht wird, und der jeweilige Montage- und Demontageaufwand minimiert werden kann. Insbesondere soll ein Anschlussbereich eines Wechselrichters zum An- und Abschließen der Komponenten sowie der Überprüfung des Wechselrichters besonders einfach und rasch zugänglich sein. Nachteile bekannter optoelektronischer Bedieneinheiten und bekannter Wechselrichtergehäuse sollen vermieden oder zumindest reduziert werden.

Gelöst wird die erfindungsgemäße Aufgabe durch eine oben genannte optische Bedieneinheit, wobei zwischen jeder Bedienfläche und der Lichtquelle und dem Lichtdetektor eines Reflexions-Lichttasters ein Lichtleiter angeordnet ist, und eine Signallichtquelle zur Aussendung von Licht im sichtbaren Wellenlängenbereich derart angeordnet ist, sodass das von der Signallichtquelle ausgesendete Licht im sichtbaren Wellenlängenbereich über den Lichtleiter auf die Bedienfläche projizierbar ist. Durch die Anordnung eines Lichtleiters zwischen Reflexions-Lichttaster und Bedienfläche kann der Reflexions-Lichttaster von der Bedienfläche entfernt angeordnet werden und somit die aufwändige Verkabelung des Reflexions-Lichttasters mit der jeweiligen Auswerteelektronik verhindert werden. Somit überbrückt der vorgesehene Lichtleiter zwischen Reflexions-Lichttaster und Bedienfläche die üblicherweise vorhandene Verkabelung, wodurch der Aufwand für die Herstellung und Demontage der Verkabelung entfällt. Weiters wird durch die zusätzliche Verwendung des Lichtleiters zur Übertragung des von einer Signallichtquelle ausgesendeten sichtbaren Lichts auf die Bedienfläche auf die Verkabelung für üblicherweise vorgesehene Signalleuchten und Anzeigen vermieden. Die Signallichtquelle kann als Signal zur Ausgabe eines Bestätigungssignals nach der Bedienung der optoelektronischen Bedieneinheit oder auch zur Anzeige bestimmter Betriebszustände der Vorrichtung herangezogen werden. Jedenfalls zeichnet sich die gegenständliche optoelektronische Bedieneinheit durch die Verwendung zumindest eines Lichtleiters sowohl für den Empfang der Bedieninformation als auch zur Ausgabe einer optischen Bestätigung oder eines optischen Signals aus. Die optoelektronische Bedieneinheit kann auch mehrere Reflexions-Lichttaster und mehrere Bedienflächen aufweisen, welche jeweils durch einen Lichtleiter miteinander verbunden sind. Die Reflexions-Lichttaster weisen jeweils zumindest eine Lichtquelle und zumindest einen Lichtdetektor auf, welche nebeneinander angeordnet sind und das Vorhandensein eines Objekts, beispielsweise eines Fingers eines Benutzers, detektieren können. Die Verwendung zumindest eines Lichtleiters in der vorliegenden optoelektronischen Bedieneinheit ermöglicht eine größere Designfreiheit bei der Gestaltung des Gehäuses der zu bedienenden Vorrichtung, beispielsweise des Wechselrichtergehäuses, und vermeidet die mit mechanischen Tasten oder Schaltern verbundene Problematik der Verkabelung zur Frontseite des Gehäuses. Neben den weiteren bekannten Vorteilen von optoelektronischen Bedieneinheiten, wie der galvanischen Trennung und der Robustheit gegenüber elektromagnetischen Einflüssen und mechanischem Verschleiß, sind derartige optoelektronische Bedieneinheiten auch flexibler, da mit einer Bedienfläche verschiedene Funktionen ausgelöst werden können, indem die Auswerteelektronik entsprechend ausgelegt und programmiert wird. Beispielsweise kann auch schon die Annäherung bzw. sogar die Annäherungsgeschwindigkeit des Fingers an die Bedienfläche detektiert werden. Die gegenständliche optoelektronische Bedieneinheit zeichnet sich durch einfachen Aufbau und niedrige Herstellungskosten aus.

Wenn die Signallichtquelle zwischen der Lichtquelle und dem Lichtdetektor eines Reflexions-Lichttasters angeordnet ist, kann einerseits Platz gespart werden und andererseits durch die Signallichtquelle eine Trennung zwischen Lichtquelle und Lichtdetektor des Reflexions-Lichttasters geschaffen werden. Die Signallichtquelle zur Aussendung eines Bestätigungssignals für die Bestätigung einer Bedienung der optoelektronischen Bedieneinheit ist somit in der Mitte des Reflexions-Lichttasters angeordnet, wodurch derselbe Lichtleiter der zur Weiterleitung des Lichts des Reflexions-Lichttasters angeordnet ist, auch zur Leitung des Lichts der Signallichtquelle herangezogen werden kann. Das Licht der Signallichtquelle wird dann auf die Bedienfläche, welche gleichzeitig zur Bedienung der optoelektronischen Bedieneinheit dient, projiziert. Bei der Verwendung der Signallichtquelle zur Abgabe eines Feedback-Signals für die Bedienung der optoelektronischen Bedieneinheit ist diese Anordnung besonders vorteilhaft, da die ordnungsgemäße Bedienung der optoelektronischen Bedieneinheit durch Beleuchten der Bedienfläche besonders deutlich angezeigt werden kann. Die Reflexions-Lichttaster allenfalls zusammen mit einer oder mehreren Signallichtquellen können in heute üblichen Halbleitertechnologien besonders klein und platzsparend aber auch kostengünstig hergestellt werden.

Gemäß einem Merkmal der Erfindung ist die Bedienfläche durch den Lichtleiter gebildet. In diesem Fall wird die Stirnseite des Lichtleiters selbst als Bedienfläche verwendet, weshalb kein eigener Bauteil zur Bildung der Bedienfläche vorgesehen werden muss. Durch die Gestaltung des Querschnitts des Lichtleiters kann auf die Größe und Form der Bedienfläche Einfluss genommen werden.

Die Lichtquelle und der Lichtdetektor des Reflexions-Lichttasters können durch eine Infrarot-Leuchtdiode und einen Infrarotdetektor, vorzugsweise mit Sende- bzw. Detektionsmaxima bei einer Wellenlänge zwischen 850nm und 900nm, gebildet sein. Diese Wellenlängenbereiche sind für die Detektion vorteilhaft, da das sichtbare Umgebungslicht weniger Einfluss auf die Detektion hat. Auch kann bei Verwendung von Infrarotlicht eine höhere Empfindlichkeit der optoelektronischen Bedieneinheit erzielt werden.

Wenn die Signallichtquelle zur Aussendung von Licht im sichtbaren Wellenlängenbereich durch eine RGB-Leuchtdiode gebildet ist, kann die Signallichtquelle zur Aussendung von Signalen in verschiedenen Farben herangezogen werden. Mehrfarbige RGB-Leuchtdioden, welche rote, grüne und blaue Leuchtdioden kombinieren, können durch entsprechende Mischung der Intensitäten der einzelnen Leuchtdioden zur Aussendung verschiedenster Farben verwendet werden. Derartige Leuchtdioden sind mittlerweile auch besonders kostengünstig erhältlich.

Der Lichtleiter ist idealerweise aus Polycarbonaten gebildet und vorzugsweise im Spritzgießverfahren hergestellt. Polycarbonate sind thermoplastische Kunststoffe, die relativ leicht verarbeitet werden können und darüber hinaus Licht besonders gut leiten können bzw. für Licht entsprechend durchlässig sind. Darüber hinaus lassen sich Polycarbonate auch einfärben, wodurch die Gestaltungsmöglichkeiten der optoelektronischen Bedieneinheit oder des mit der optoelektronischen Bedieneinheit ausgestatteten Gehäuses noch weiter erhöht werden können.

Alternativ dazu kann der Lichtleiter auch aus anderen lichtdurchlässigen und lichtleitenden Materialien, wie z.B. Glas, hergestellt sein. Glas ist zwar aufwändiger in der Herstellung, kann aber hinsichtlich einer Alterung gegenüber Kunststoffen vorteilhaft sein.

Zusätzlich kann ein Lichtsensor zur Detektion von Umgebungslicht vorgesehen und vorzugsweise neben dem Reflexions-Lichttaster angeordnet sein, welcher Lichtsensor mit der Auswerteelektronik verbunden ist. Durch die Anordnung eines Lichtsensors zur Detektion des Umgebungslichts kann die Lichtstärke der Signallichtquelle an das Umgebungslicht angepasst werden, ähnlich wie es bei der Helligkeit des Bildschirms von Anzeigen, beispielsweise von Smartphones, bekannt ist. Wenn der Lichtsensor zur Detektion von Umgebungslicht neben dem Reflexions-Lichttaster angeordnet ist, kann dieser das über den Lichtleiter eindringende Umgebungslicht analysieren und auswerten. Alternativ dazu kann der Lichtsensor zur Detektion von Umgebungslicht auch an einer anderen geeigneten Stelle des Gehäuses der Vorrichtung, welche mit der optoelektronischen Bedieneinheit versehen wird, angeordnet werden.

Wenn die Bedienfläche in einem Winkel zum Reflexions-Lichttaster angeordnet ist und der Lichtleiter eine Umlenkfläche aufweist, sodass das Licht im Lichtleiter um diesen Winkel umlenkbar ist, kann ein flexiblerer Einbau der optoelektronischen Bedieneinheit in eine entsprechende Vorrichtung, insbesondere eines Wechselrichters, erzielt werden. Der Winkel kann theoretisch beliebig, beispielsweise zwischen 10° und 170°, vorzugsweise im Wesentlichen 90°, betragen. Eine im Wesentlichen senkrechte Anordnung zwischen Bedienfläche und Reflexions-Lichttaster ist bei vielen praktischen Anwendungen von Vorteil, wenn die Frontfläche bzw. Bedienfläche einer Vorrichtung im Wesentlichen senkrecht zur Platine, welche auch die Auswerteelektronik der optoelektronischen Bedieneinheit und den Reflexions-Lichttaster aufweist, angeordnet ist.

Vorzugsweise sind die Bedienfläche und bzw. oder die Umlenkfläche des Lichtleiters poliert ausgebildet. Durch das Polieren der Bedienfläche kann die Empfindlichkeit der optoelektronischen Bedieneinheit erhöht werden, da weniger Streulicht eingefangen wird, das Einfluss auf die Empfindlichkeit der Auslösung des Reflexions-Lichttasters haben könnte. Bei der Umlenkfläche zum Umlenken des Lichts im Lichtleiter hat sich ein Polieren ebenfalls als vorteilhaft herausgestellt, da dadurch die Reflexionseigenschaften des im Lichtleiter transportierten Lichts verbessert und Verluste minimiert werden können. In der Folge resultieren auch längere Strecken die mit dem Lichtleiter zwischen der Bedienfläche und dem Reflexions-Lichttaster überbrückt werden können.

Gelöst wird die erfindungsgemäße Aufgabe auch durch ein oben genanntes Wechselrichtergehäuse, wobei der Anschlussbereich unterhalb des Bedienbereichs angeordnet und im Bedienbereich eine oben beschriebene optoelektronische Bedieneinheit vorgesehen ist. Ein derartiges Wechselrichtergehäuse zeichnet sich durch einfache und kostengünstige Herstellung, aber auch geringeren Montage- und Demontageaufwand aus. Beispielsweise kann der zumindest eine Lichtleiter in einem Gehäuseteil verbunden oder mit diesem einstückig hergestellt sein, wohingegen die Elektronik einschließlich des Reflexions-Lichttasters und der Auswerteelektronik im anderen Gehäuseteil befestigt ist. Eine entsprechende Konstruktion vorausgesetzt, müssen die Gehäuseteile lediglich miteinander verbunden werden und es wird automatisch eine Verbindung zwischen der Bedienfläche und dem Reflexions-Lichttaster hergestellt, indem der zumindest eine Lichtleiter die Distanz zwischen Bedienfläche und Reflexions-Lichttaster überbrückt. Es müssen keinerlei Arbeitsschritte zur Verbindung der optoelektronischen Bedieneinheit mit der Auswerteelektronik vorgenommen werden. Dementsprechend ist auch die Wartung einer mit einer solchen optoelektronischen Bedieneinheit ausgestatteten Vorrichtung, beispielsweise eines Wechselrichters, wesentlich vereinfacht, da bloß ein Gehäuseteil abgenommen werden muss und danach gleich der darunter angeordnete Anschlussbereich für die Wartung zugänglich ist. Verkabelungen für Bedienelemente müssen nicht, wie bisher üblich, vor der Wartung entfernt werden.

Vorteilhafter Weise ist die Bedienfläche bzw. der Lichtleiter mit der Bedienfläche zusammen mit einem Gehäuseteil des Wechselrichtergehäuses hergestellt. Dabei eignet sich vorzugsweise ein Zwei- oder Mehrkomponenten-Spritzgießverfahren zur Herstellung des entsprechenden Gehäuseteils. Bei Zwei- oder Mehrkomponenten-Spritzgießverfahren werden zwei oder mehrere verschiedene Kunststoffe hintereinander verarbeitet, wodurch dem hergestellten Gegenstand bestimmte Designs oder bestimmte Eigenschaften verliehen werden können. Beim gegenständlichen Wechselrichtergehäuse kann der Gehäuseteil beispielsweise durch einen geeigneten undurchsichtigen Kunststoffwerkstoff, beispielsweise Polypropylen, hergestellt werden, wohingegen für den zumindest einen Lichtleiter vorzugsweise Polycarbonate verwendet werden. Beim Vorsehen mehrerer Lichtleiter für die Verbindung mehrerer Bedienflächen mit mehreren Reflexions-Lichttastern können diese Lichtleiter auch über zumindest einen gemeinsamen Steg miteinander verbunden werden, wodurch die mechanische Stabilität der Lichtleiter und des damit verbundenen Gehäuseteils erhöht werden kann.

Zwischen den zumindest zwei Gehäuseteilen kann eine Dichtung angeordnet sein. Insbesondere bei einer Verwendung des Gehäuses im Außenbereich, wie es bei Wechselrichtergehäusen üblich ist, ist eine solche Dichtung unbedingt erforderlich bzw. vorteilhaft, um die Lebensdauer der im Wechselrichtergehäuse enthaltenen elektronischen Komponenten zu erhöhen. Die Dichtung kann im einfachsten Fall durch ein umlaufendes Band oder dergleichen aus elastischem Material, wie z.B. Silikon, gebildet sein.

Jedes Befestigungselement zur lösbaren Befestigung der Gehäuseteile des Wechselrichtergehäuses kann durch einen Drehbolzen und eine Blattfeder mit einer Öffnung für die Aufnahme eines Endes des Drehbolzens gebildet sein, wobei der Drehbolzen in der geöffneten Stellung aus der bzw. in die Öffnung der Blattfeder bringbar ist, und in einer gegenüber der geöffneten Stellung verdrehten, geschlossenen Stellung die Blattfeder vorgespannt in axialer Richtung fixiert. Eine derartige Realisierung eines Befestigungselements ermöglicht eine besonders einfache und rasche Befestigung der Gehäuseteile miteinander, wobei auch gleichzeitig eine entsprechende Dichtheit des Gehäuses erzielt werden kann. Die Drehbolzen können so gestaltet werden, dass sie manuell von der geöffneten Position in die geschlossene Position verdreht werden können oder mithilfe eines geeigneten Werkzeugs, wie z.B. einem Schraubenzieher. Durch das Zusammenspiel des Drehbolzens mit einer Blattfeder kann eine entsprechende Druckkraft auf die Gehäuseteile des Wechselrichtergehäuses aufgebracht werden, welche für die notwendige Dichtheit sorgt.

Dabei rastet der Drehbolzen jedes Befestigungselements in der geschlossenen Stellung bevorzugt in die Öffnung der Blattfeder ein. Durch ein derartiges Ein- bzw. Verrasten der Blattfeder wird einerseits ein sicherer Halt des Befestigungselements in der geschlossenen Stellung erzielt. Andererseits kann bei entsprechender Gestaltung des Drehbolzens, der Blattfeder und des Gehäuseteils ein akustisches Signal beim Einrasten und allenfalls Öffnen des Befestigungselements hervorgerufen werden. Darüber hinaus wird durch die Konstruktion des Befsetigungselements ein Widerstand erzeugt, der beim Schließen und allenfalls Öffnen des Befestigungselements mit einem spürbaren Ruck überwunden werden muss. Dies dient als Rückmeldung eines ordnungsgemäß geschlossenen bzw. geöffneten Befestigungselements. Das bedeutet, dass der Monteur beim Schließen bzw. Öffnen des Befestigungselements durch das akustische Signal hört und die Überwindung des Widerstands spürt, ob die geschlossene bzw. geöffnete Stellung erreicht wurde und der Drehbolzen in der geschlossenen Stellung entsprechend eingerastet ist bzw. in eine geöffnete Stellung gebracht wurde.

Wenn an einem Gehäuseteil eine Aufnahme für eine den zumindest einen Reflexions-Lichttaster aufweisende Platine derart vorgesehen ist, dass die Platine in einem Winkel zur Bedienfläche angeordnet ist, kann eine größere Flexibilität beim Einbau der Komponenten in das Wechselrichtergehäuse erzielt werden. Der Winkel kann beispielsweise zwischen 10° und 170°, vorzugsweise im Wesentlichen 90° betragen. Wie bereits oben im Zusammenhang mit der optoelektronischen Bedieneinheit erwähnt, kann dadurch die Anordnung der Bedienflächen in Bezug auf die elektronischen Komponenten im Wechselrichtergehäuse flexibler gestaltet werden.

Schließlich wird die erfindungsgemäße Aufgabe auch durch ein Wechselrichtergehäuse mit zumindest zwei über Befestigungselemente lösbar miteinander verbindbaren Gehäuseteilen, einem Anschlussbereich und an einem Gehäuseteil vorgesehenen Bedienbereich gelöst, wobei jedes Befestigungselement durch einen Drehbolzen und eine Blattfeder mit einer Öffnung für die Aufnahme eines Endes des Drehbolzens gebildet ist, wobei der Drehbolzen in der geöffneten Stellung aus der bzw. in die Öffnung der Blattfeder bringbar ist, und in einer gegenüber der geöffneten Stellung verdrehten, geschlossenen Stellung die Blattfeder vorgespannt in axialer Richtung fixiert. Durch diese Ausbildung des Befestigungselements kann eine einfache und rasche Befestigung der Gehäuseteile des Wechselrichtergehäuses erzielt werden und somit die Montage und Demontage erleichtert werden. Zugleich kann durch die entsprechende Ausgestaltung der Befestigungselemente eine optimale Dichtheit des Wechselrichtergehäuses erzielt werden, welche auch meist erforderlich ist, da Wechselrichtergehäuse im Allgemeinen für die Anordnung im Außenbereich konzipiert sind. Die Betätigung des Drehbolzens jedes Befestigungselements kann manuell durch entsprechende Ausgestaltung des Kopfes des Drehbolzens erfolgen oder auch mithilfe eines geeigneten Werkzeugs, wie z.B. eines Schraubenziehers, der in eine dafür vorgesehene Aufnahme am Kopf des Drehbolzens eingebracht werden kann.

Dabei rastet der Drehbolzen jedes Befestigungselements in der geschlossenen Stellung bevorzugt in die Öffnung der Blattfeder ein. Durch das Ein- oder Verrasten des Drehbolzens in der Blattfeder wird einerseits ein Halten in der geschlossenen Stellung unterstützt und ein ungewolltes Öffnen des Befestigungselements verhindert. Andererseits kann durch entsprechende Ausgestaltung der Blattfeder und des Gehäuseteils erreicht werden, dass beim Einrasten des Drehbolzens in der geschlossenen Stellung ein akustisches Signal durch die Blattfeder in Kombination mit dem Gehäuseteil abgegeben und ein Widerstand erzeugt wird, der beim Schließen des Befestigungselements mit einem spürbaren Ruck überwunden werden muss. Dadurch wird dem Monteur das ordnungsgemäße Einrasten in der geschlossenen Stellung angezeigt. Somit muss der Monteur das Befestigungselement so lange betätigen, beispielsweise eine Vierteldrehung, bis er das akustische Signal hört und die Überwindung des Widerstands spürt, um sicherzustellen, dass sich das Befestigungselement ordnungsgemäß in der geschlossenen Stellung befindet. Wie oben beschrieben, kann das akustische Signal und der spürbare Widerstand ebenso beim Öffnen des Befestigungselements hervorgerufen werden.

Wenn an einem Gehäuseteil eine Aufnahme für eine den zumindest einen Reflexions-Lichttaster aufweisende Platine derart vorgesehen ist, dass die Platine in einem Winkel zur Bedienfläche angeordnet ist, kann eine größere Flexibilität beim Einbau der Komponenten in das Wechselrichtergehäuse erzielt werden. Der Winkel kann beispielsweise zwischen 10° und 170°, vorzugsweise im Wesentlichen 90°, betragen. Dadurch wird der Gestaltungsmöglichkeit hinsichtlich der Anordnung der Bedienfläche und der Platine, welche den Reflexions-Lichttaster und die Auswerteelektronik enthält, ein größerer Spielraum eingeräumt.

Zwischen den zumindest zwei Gehäuseteilen kann eine Dichtung angeordnet sein. Diese Dichtung gewährleistet eine höhere Lebensdauer der im Inneren des Wechselrichtergehäuses befindlichen Komponenten. Im einfachsten Fall kann die Dichtung durch einen umlaufenden Streifen oder Schlauch oder dergleichen aus elastischem Material, beispielsweise Silikon, gebildet sein.

Die Erfindung wird anhand der beigefügten Zeichnungen näher erläutert. Darin zeigen:
- Fig. 1: eine in einem Teil eines Wechselrichtergehäuses eingebaute optoelektronische Bedieneinheit der vorliegenden Erfindung in geschnittener Darstellung;
- Fig. 2: eine Ansicht auf den Reflexions-Lichttaster der optoelektronischen Bedieneinheit gemäß Fig. 1;
- Fig. 3: eine Draufsicht auf die Bedienfläche der optoelektronischen Bedieneinheit gemäß Fig. 1;
- Fig. 4: das Prinzip eines Wechselrichtergehäuses in Explosionsdarstellung;
- Fig. 5: das Wechselrichtergehäuse gemäß Fig. 4 in zusammengebautem Zustand;
- Fig. 6: eine Explosionsdarstellung einer Ausführungsform eines Befestigungselements zur Befestigung der Gehäuseteile eines Wechselrichtergehäuses;
- Fig. 7: das Befestigungselement gemäß Fig. 6 im zusammengebauten Zustand der Gehäuseteile des Wechselrichtergehäuses;
- Fig. 8: eine Draufsicht auf die Blattfeder des Befestigungselements gemäß den Figuren 6 und 7; und
- Fig. 9: eine Variante des Lichtleiters der optoelektronischen Bedieneinheit gemäß Fig. 1 in perspektivischer Ansicht.

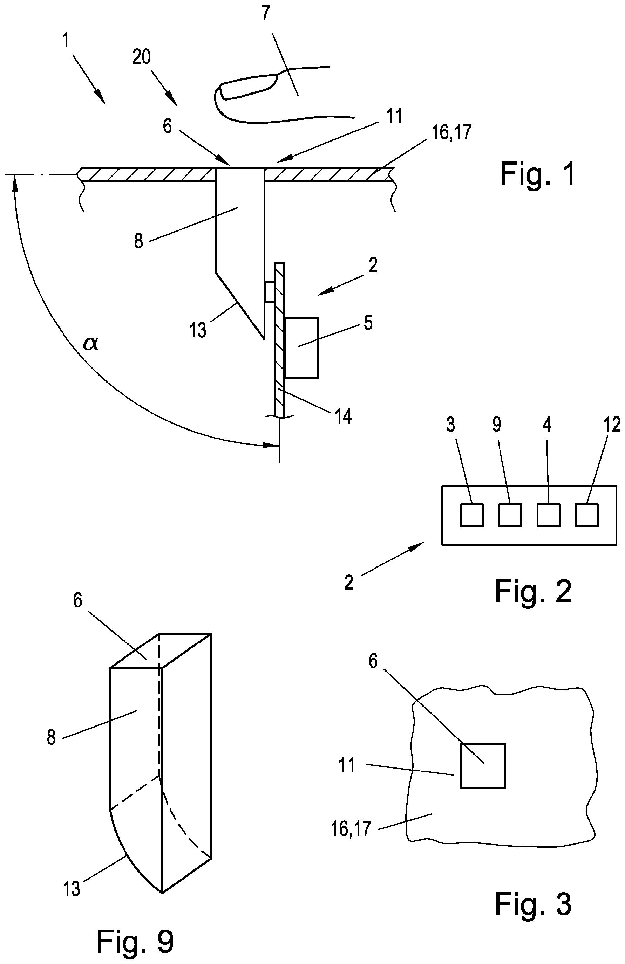

Fig. 1 zeigt eine in einem Teil eines Wechselrichtergehäuses 15 eingebaute optoelektronische Bedieneinheit 1 der vorliegenden Erfindung in geschnittener Darstellung. In einem Gehäuseteil 16 oder 17 des Wechselrichtergehäuses 15 ist zur Bildung des Bedienbereichs 20 eine optoelektronische Bedieneinheit 1 angeordnet, welche zumindest einen Reflexions-Lichttaster 2 aufweist, der jeweils zumindest eine Lichtquelle 3 und jeweils einen neben der Lichtquelle 3 angeordneten Lichtdetektor 4 beinhaltet (s. Fig. 2). Der Reflexions-Lichttaster 2 ist mit einer entsprechenden Auswerteelektronik 5 verbunden und wird über eine Bedienfläche 6 durch Annäherung eines Objekts 7, beispielsweise eines Fingers eines Bedieners, entsprechend betätigt. Erfindungsgemäß ist zwischen jeder Bedienfläche 6 und der Lichtquelle 3 und dem Lichtdetektor 4 eines Reflexions-Lichttasters 2 ein Lichtleiter 8 angeordnet, über den das Licht der Lichtquelle 3 des Reflexions-Lichttasters 2 zur Bedienfläche 6 und von dort zurück zum Lichtdetektor 4 geleitet werden kann. Im Falle einer Umlenkung der Richtung des Lichts ist eine entsprechende Umlenkfläche 13 im Lichtleiter 8 angeordnet. Die Bedienfläche 6 kann gesondert ausgebildet sein oder durch die Stirnfläche des Lichtleiters 8 gebildet werden. Im dargestellten Ausführungsbeispiel ist der Reflexions-Lichttaster 2 und die entsprechende Auswerteelektronik 5 auf einer Platine angeordnet, die hier in einem Winkel α von im Wesentlichen 90° zur Bedienfläche 6 angeordnet ist. Die Bedienfläche 6 ist eben mit der Fläche des Gehäuseteils 16 oder 17 ausgebildet. Durch die Umlenkfläche 13 des Lichtleiters 8 wird das Licht um diesen Winkel α entsprechend umgelenkt. Bei der Realisierung anderer Winkel α muss der Lichtleiter nur entsprechend umgestaltet werden, sodass eine entsprechende Umlenkung des Lichts des Reflexions-Lichttasters 2 zur Bedienfläche 6 ermöglicht wird. Auf der Platine 14, vorzugsweise zwischen der Lichtquelle und dem Lichtdetektor 4 des Reflexions-Lichttasters 2 (s. Fig. 2) ist eine Signallichtquelle 9 angeordnet, dessen Licht im sichtbaren Wellenlängenbereich ebenfalls über den Lichtleiter 8 auf die Bedienfläche 6 projizierbar ist. Die Lichtquelle 3 und der Lichtdetektor 4 des Reflexions-Lichttasters 2 ist vorzugsweise durch eine Infrarot-Leuchtdiode und einen Infrarotdetektor, vorzugsweise mit Sende- bzw. Detektionsmaxima, bei einer Wellenlänge λ zwischen 850 nm und 900 nm gebildet. Die Signallichtquelle 9 kann beispielsweise durch eine RGB-Leuchtdiode gebildet sein, um die Aussendung verschiedenfarbigen Lichts zu ermöglichen.

Der Lichtleiter 8 ist vorzugsweise aus Polycarbonaten gebildet und vorzugsweise im Spritzgießverfahren hergestellt. Eine Herstellung aus Glas ist jedoch ebenso möglich. Vorzugsweise neben dem Reflexions-Lichttaster 2 bzw. neben dessen Lichtquelle 3 oder Lichtdetektor 4 kann ein Lichtsensor 12 zur Detektion von Umgebungslicht vorgesehen und vorzugsweise mit der Auswerteelektronik 5 verbunden sein.

Wie der Draufsicht auf die Bedienfläche 6 gemäß Fig. 3 entnommen werden kann, ist die Bedienfläche 6 gegenüber der umgebenden Fläche 11 vorzugsweise mit einer anderen Beschaffenheit ausgebildet, vorzugsweise poliert, sodass einerseits die Bedienfläche 6 von der umgebenen Fläche 11 abgehoben dargestellt und andererseits die Empfindlichkeit der optoelektronischen Bedieneinheit 1 erhöht werden kann.

Die Auswertung des Reflexions-Lichttasters 2 in der Auswerteelektronik 5 wird vorzugsweise softwaremäßig vorgenommen, indem die Dauer und der Grad der Abdunkelung der Bedienfläche 6 durch das Objekt 7 erfasst und mit voreingestellten Werten verglichen werden. Dadurch können verschiedene Bedienmuster abgefragt und verschiedene Funktionen der Vorrichtung ausgelöst werden. Beispielsweise kann ein langes oder kurzes Abdunkeln der Bedienfläche 6 durch ein Objekt 7 oder ein mehrfaches Abdecken der Bedienfläche 6 durch ein Objekt 7 innerhalb einer vorgegebenen Zeitspanne detektiert werden und zum Auslösen bestimmter Funktionen der Vorrichtung herangezogen werden.

Die dargestellte optische Bedieneinheit 1 zeichnet sich durch einen verringerten Montage- und Demontageaufwand aus, da keine Verkabelung zwischen dem Bedienbereich 20 am Gehäuseteil 16 oder 17 und dem Reflexions-Lichttaster 2 bzw. der Auswerteelektronik 5 hergestellt werden muss, wenn die Gehäuseteile 16, 17 gelöst werden, um die Vorrichtung zu montieren oder demontieren oder eine Wartung vornehmen zu können. Die Länge und Gestaltung des Lichtleiters 8 ist in relativ weiten Grenzen möglich und der Lichtleiter 8 und der entsprechende Gehäuseteil 16 oder 17 können relativ einfach und kostengünstig in einem Herstellungsverfahren hergestellt werden oder der Lichtleiter 8 kann relativ einfach am Gehäuseteil 16, 17 angebracht werden.

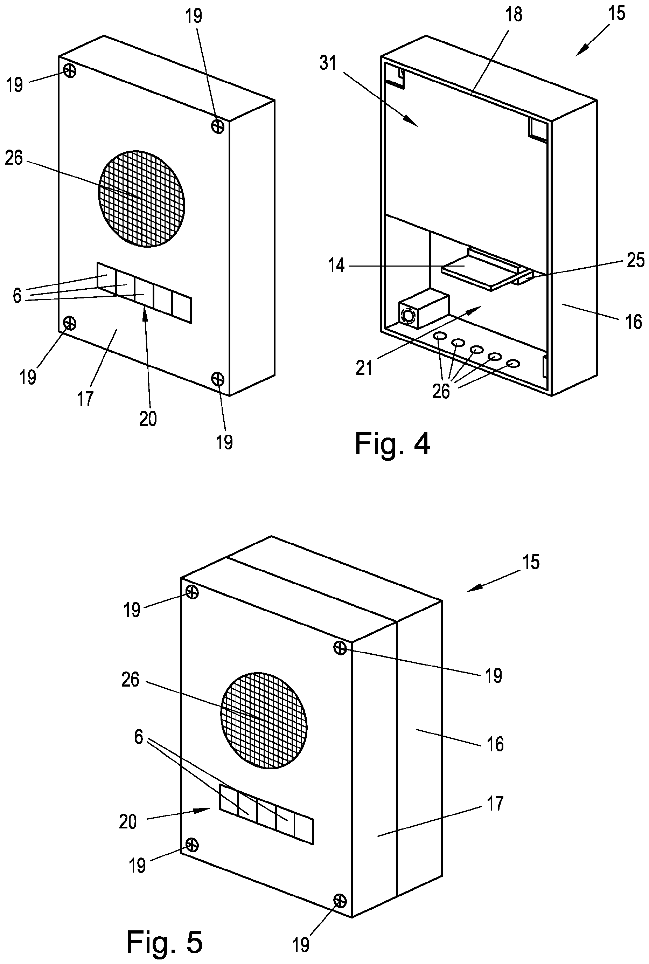

Fig. 4 zeigt das Prinzip eines Wechselrichtergehäuses 15, wie es für einen Photovoltaik-Weschselrichter eingesetzt wird, in Explosionsdarstellung. Das Wechselrichtergehäuse 15 besteht im Wesentlichen aus zwei Gehäuseteilen 16, 17, welche über entsprechende Befestigungselemente 19 miteinander lösbar verbunden werden können. An dem einen Gehäuseteil 16 des Wechselrichtergehäuses 15, welches üblicherweise an einer Wand oder dergleichen (nicht dargestellt) montiert wird, befindet sich üblicherweise im unteren Bereich ein Anschlussbereich 21, welcher von einem Leistungsbereich 31, der die leistungselektronischen Komponenten des Wechselrichters aufweist, getrennt ist. Im Anschlussbereich 21 erfolgt der Anschluss der Photovoltaik-Module mit dem DC-Eingang des Wechselrichters und der Verbraucher bzw. des Versorgungsnetzes mit dem AC-Ausgang des Wechselrichters über entsprechende Steckverbindungen oder dergleichen (nicht dargestellt). Über entsprechende Öffnungen 26 im Gehäuseteil 16 verlaufen die entsprechenden Zuleitungen zu den Photovoltaik-Modulen und Verbrauchern bzw. dem Verbrauchernetz. Im Anschlussbereich 21 des Gehäuseteils 16 befinden sich Aufnahmen 25 für eine Platine 14, welche die notwendigen Komponenten der optoelektronischen Bedieneinheit 1, wie die Reflexions-Lichttaster 2 und die Auswerteelektronik 5, enthalten. Über eine Dichtung 18 werden die beiden Gehäuseteile 16, 17 im geschlossenen Zustand entsprechend abgedichtet.

Im vorderen Gehäuseteil 17 des Wechselrichtergehäuses 15 sind die Befestigungselemente 19 entsprechend angeordnet und im Bedienbereich 20 befinden sich die Bedienelemente zur Bedienung des Wechselrichters. Erfindungsgemäß befinden sich die Bedienflächen 6 der optoelektronischen Bedieneinheit 1 (s. Fig. 1-3) im Bedienbereich 20 des Gehäuseteils 17, sodass eine einfache und unkomplizierte Bedienung der Funktionen des Wechselrichters ermöglicht wird. Gleichzeitig dienen die Bedienflächen 6 zur Ausgabe optischer Signale über die Signallichtquellen 9 über die entsprechenden Bedienflächen 6.

Vorteilhaft ist auch, dass der Bedienbereich 20 über dem Anschlussbereich 21 im anderen Gehäuseteil 16 angeordnet ist, sodass die Komponenten der optoelektronischen Bedieneinheit 1 auch keine Störung der Verkabelungen im Anschlussbereich 21 bewirken. Ebenso kann der Gehäuseteil 17 oder auch nur ein Teil davon, wie z.B. ein entsprechend gestalteter Deckel (nicht dargestellt), in einfacher Weise geöffnet und geschlossen werden, um einen Zugang zum Anschlussbereich 21 zu ermöglichen. Der Gehäuseteil 17 kann auch zwei- oder mehrteilig ausgebildet sein, sodass beispielsweise der Anschlussbereich 21 und der Leistungsbereich 31 getrennt voneinander geöffnet werden kann.

Fig. 5 zeigt das Wechselrichtergehäuse 15 gemäß Fig. 4 in zusammengebautem Zustand. Im geschlossenen Zustand des Wechselrichtergehäuses 15 befinden sich die beiden Gehäuseteile 16, 17 entsprechend übereinander und die Befestigungselemente 19 werden in die verschlossene Stellung gebracht. Somit kann der Wechselrichter über die Bedienflächen 6 der optoelektronischen Bedieneinheit gesteuert oder ein- und ausgeschaltet werden. Bei ordnungsgemäßer Befestigung der Befestigungselemente 19 wird eine entsprechende Dichtheit zwischen den beiden Gehäuseteilen 16, 17 erzielt, welche durch die in Fig. 4 dargestellte und beschrieben Dichtung 18 gewährleistet bzw. verbessert wird.

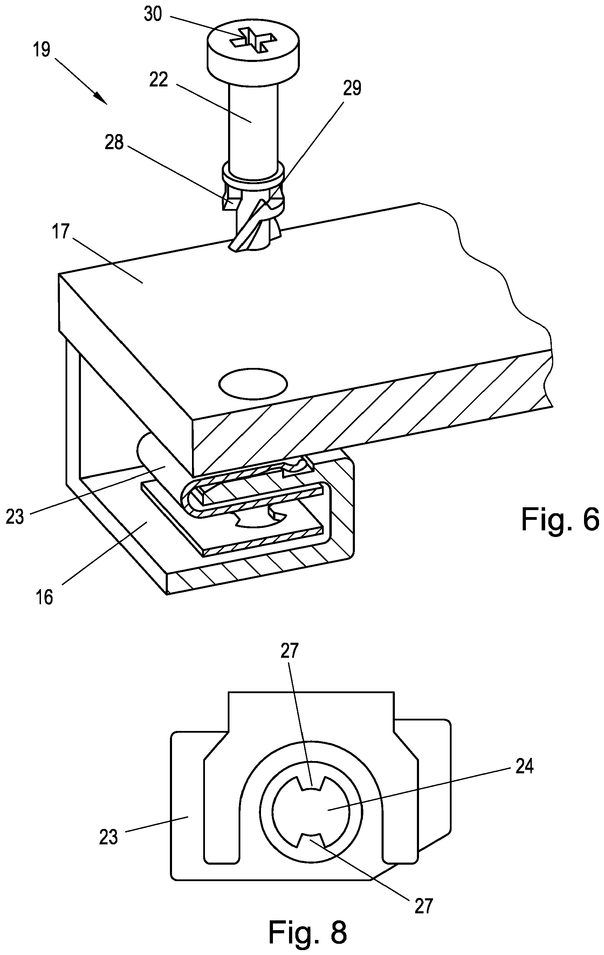

Fig. 6 zeigt eine Explosionsdarstellung einer Ausführungsform eines Befestigungselements 19 zur Befestigung der Gehäuseteile 16, 17 eines Wechselrichtergehäuses 15. Die beiden Gehäuseteile 16, 17 werden über das Befestigungselement 19 miteinander verbunden, wobei das Befestigungselement 19 aus einem Drehbolzen 22 und einer Blattfeder 23 besteht. Der Drehbolzen 22 weist am Kopf eine Aufnahme 30 für ein entsprechendes Werkzeug, beispielsweise einen Schraubzieher (nicht dargestellt), auf. Im unteren Bereich des Drehbolzens 22 ist eine Kulisse 28 angeordnet, mit einer Rastnase 29, die in eine entsprechende Öffnung 24 mit Rastnasen 27 in der Blattfeder 23 (s. Fig. 8) einrastet und bei Verdrehung um 90° eine sichere Verbindung der beiden Gehäuseteile 16 und 17 unter Vorspannung der Blattfeder 23 gewährleistet. Durch entsprechende Gestaltung der Rastnase 29 am Drehbolzen 22 und der Blattfeder 23 und deren Vorspannung zusammen mit dem Gehäuseteil 16 kann erzielt werden, dass ein akustisches Signal beim Einrasten des Drehbolzens 22 in der verschlossenen Stellung und allenfalls Öffnen des Drehbolzens 22 erzeugt wird, das dem Monteur das ordnungsgemäße Erreichen der geschlossenen bzw. geöffneten Stellung anzeigt. Auch spürt der Monteur das Überwinden der Rastnase 29 durch einen entsprechenden Ruck, wenn die geschlossene bzw. geöffnete Stellung des Befestigungselements 19 erreicht wurde. Idealerweise wird die Blattfeder 23 aus gehärtetem Metall, insbesondere Saarstahl C67S, hergestellt und weist im parallelen Zustand vorzugsweise eine Kraft von 100N bis 150N, insbesondere 125N auf. Der Gehäuseteil 16 ist vorzugsweise aus Aluminium im Druckgussverfahren hergestellt. Der Gehäuseteil 17 kann auch aus Kunststoff bestehen.

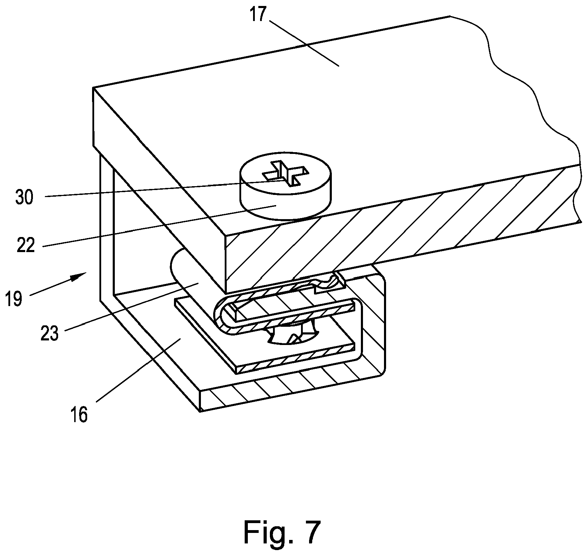

Fig. 7 zeigt das Befestigungselement 19 gemäß Fig. 6 im zusammengebauten Zustand der Gehäuseteile 16, 17 des Wechselrichtergehäuses 15. Durch die Vorspannung der Blattfeder 23 und dem in geschlossene Stellung gedrehten Befestigungselement 19 wird der Gehäuseteil 16 gegenüber dem Gehäuseteil 17 entsprechend verspannt, wodurch allenfalls unter Zwischenlage einer Dichtung 18 (nicht dargestellt) eine optimale Dichtheit für das Wechselrichtergehäuse 15 erzielt werden kann. Die Vorspannung der Blattfedern 23 bewirkt, dass durch die Befestigungselemente 19 die zur Erzielung einer entsprechenden Dichtheit des Wechselrichtergehäuses 15 notwendige Kraft aufgebaut werden kann. Auch erfolgt das Einrasten des Befestigungselements 19 in die geschlossene Stellung durch die Vorspannung der Blattfeder 23 mit einer erhöhten Kraft und Beschleunigung, wodurch auch das akustische Signal beim Einrasten in die geschlossene bzw. auch geöffnete Stellung verstärkt wird.

Schließlich zeigt Fig. 9 eine Variante des Lichtleiters 8 der optoelektronischen Bedieneinheit 1 gemäß Fig. 1 in perspektivischer Ansicht. Bei dieser Variante ist gegenüber der Ausführungsform gemäß Fig. 1 die Umlenkfläche 13 des Lichtleiters 9 gewölbt ausgebildet, was zu einer Verbesserung der Führung des Lichts innerhalb des Lichtleiters 8 führen kann. Wie bereits bei der Ausführungsvariante des Lichtleiters 8 gemäß Fig. 1 erwähnt, ist die Umlenkfläche 13 vorzugsweise poliert ausgebildet. Der Gestaltung des Lichtleiters 8 sind jedoch kaum Grenzen gesetzt.

## Patentansprüche

1. Optoelektronische Bedieneinheit (1) zur Bedienung einer Vorrichtung, insbesondere eines Wechselrichters (10), mit zumindest einem Reflexions-Lichttaster (2) mit jeweils einer Lichtquelle (3) und jeweils einem neben der Lichtquelle (3) angeordneten Lichtdetektor (4), einer Auswerteelektronik (5), und mit einer über der Lichtquelle (3) und dem Lichtdetektor (4) jedes Reflexions-Lichttasters (2) angeordneten Bedienfläche (6) zur Bedienung des Reflexions-Lichttasters (2) durch die Annäherung eines Objekts (7), **dadurch gekennzeichnet, dass** zwischen jeder Bedienfläche (6) und der Lichtquelle (3) und dem Lichtdetektor (4) eines Reflexions-Lichttasters (2) ein Lichtleiter (8) angeordnet ist, und dass eine Signallichtquelle (9) zur Aussendung von Licht im sichtbaren Wellenlängenbereich derart angeordnet ist, sodass das von der Signallichtquelle (9) ausgesendete Licht im sichtbaren Wellenlängenbereich über den Lichtleiter (8) auf die Bedienfläche (6) projizierbar ist.

2. Optoelektronische Bedieneinheit (1) nach Anspruch 1, **dadurch gekennzeichnet, dass** die Signallichtquelle (9) zwischen der Lichtquelle (3) und dem Lichtdetektor (4) eines Reflexions-Lichttasters (2) angeordnet ist.

3. Optoelektronische Bedieneinheit (1) nach Anspruch 1 oder 2, **dadurch gekennzeichnet, dass** die Bedienfläche (6) durch den Lichtleiter (8) gebildet ist.

4. Optoelektronische Bedieneinheit (1) nach einem der Ansprüche 1 bis 3, **dadurch gekennzeichnet, dass** die Lichtquelle (3) und der Lichtdetektor (4) des Reflexions-Lichttasters (2) durch eine Infrarot-Leuchtdiode und einen Infrarotdetektor, vorzugsweise mit Sende- bzw. Detektionsmaxima bei einer Wellenlänge λ zwischen 850nm und 900nm, gebildet ist.

5. Optoelektronische Bedieneinheit (1) nach einem der Ansprüche 1 bis 4, **dadurch gekennzeichnet, dass** die Signallichtquelle (9) zur Aussendung von Licht im sichtbaren Wellenlängenbereich durch eine RGB-Leuchtdiode gebildet ist.

6. Optoelektronische Bedieneinheit (1) nach einem der Ansprüche 1 bis 5, **dadurch gekennzeichnet, dass** der Lichtleiter (8) aus Polycarbonaten gebildet und vorzugsweise im Spritzgießverfahren hergestellt ist.

7. Optoelektronische Bedieneinheit (1) nach einem der Ansprüche 1 bis 6, **dadurch gekennzeichnet, dass** ein Lichtsensor (12) zur Detektion von Umgebungslicht vorgesehen ist und vorzugsweise neben dem Reflexions-Lichttaster (2) angeordnet ist, welcher Lichtsensor (12) mit der Auswerteelektronik (5) verbunden ist.

8. Optoelektronische Bedieneinheit (1) nach einem der Ansprüche 1 bis 7, **dadurch gekennzeichnet, dass** die Bedienfläche (6) in einem Winkel (α) zum Reflexions-Lichttaster (2) angeordnet ist, welcher Winkel (α) zwischen 10° und 170°, vorzugsweise im Wesentlichen 90° beträgt, und dass der Lichtleiter (8) eine Umlenkfläche (13) aufweist, sodass das Licht im Lichtleiter (8) um den Winkel (α) umlenkbar ist.

9. Optoelektronische Bedieneinheit (1) nach einem der Ansprüche 1 bis 8, **dadurch gekennzeichnet, dass** die Bedienfläche (6) und bzw. oder die Umlenkfläche (13) des Lichtleiters (8) poliert ausgebildet ist.

10. Wechselrichtergehäuse (15) mit zumindest zwei über Befestigungselemente (19) lösbar miteinander verbindbaren Gehäuseteilen (16, 17), einem Anschlussbereich (21) und einem an einem Gehäuseteil (16, 17) vorgesehenen Bedienbereich (20), **dadurch gekennzeichnet, dass** der Anschlussbereich (21) unterhalb des Bedienbereichs (20) angeordnet, und im Bedienbereich (20) eine optoelektronische Bedieneinheit (1) nach einem der Ansprüche 1 bis 9 vorgesehen ist.

11. Wechselrichtergehäuse (15) nach Anspruch 10, **dadurch gekennzeichnet, dass** die Bedienfläche (6) bzw. der Lichtleiter (8) mit der Bedienfläche (6) zusammen mit einem Gehäuseteil (16, 17), vorzugsweise im Zwei- oder Mehrkomponenten-Spritzgießverfahren, hergestellt ist.

12. Wechselrichtergehäuse (15) nach Anspruch 10 oder 11, **dadurch gekennzeichnet, dass** zwischen den zumindest zwei Gehäuseteilen (16, 17) eine Dichtung (18) angeordnet ist.

13. Wechselrichtergehäuse (15) nach einem der Ansprüche 10 bis 12, **dadurch gekennzeichnet, dass** jedes Befestigungselement (19) durch einen Drehbolzen (22) und eine Blattfeder (23) mit einer Öffnung (24) für die Aufnahme eines Endes des Drehbolzens (22) gebildet ist, wobei der Drehbolzen (22) in der geöffneten Stellung aus der bzw. in die Öffnung (24) der Blattfeder (23) bringbar ist, und in einer gegenüber der geöffneten Stellung verdrehten, geschlossenen Stellung die Blattfeder (23) vorgespannt in axialer Richtung fixiert.

14. Wechselrichtergehäuse (15) nach Anspruch 13, **dadurch gekennzeichnet, dass** der Drehbolzen (22) jedes Befestigungselements (19) in der geschlossenen Stellung in die Öffnung (24) der Blattfeder (23) einrastet.

15. Wechselrichtergehäuse (15) nach einem der Ansprüche 10 bis 14, **dadurch gekennzeichnet, dass** an einem Gehäuseteil (16, 17) eine Aufnahme (25) für eine den zumindest einen Reflexions-Lichttaster (2) aufweisende Platine (14) derart vorgesehen ist, dass die Platine (14) in einem Winkel (α) von 10° bis 170°, vorzugsweise im Wesentlichen 90°, zur Bedienfläche (6) angeordnet ist.
